# EUROPEAN PATENT APPLICATION

(11) **EP 3 923 059 A1**
(43) Date of publication of application: **15.12.2021**
(21) Application number: 21179008.4
(22) Date of filing: 11.06.2021
(51) Int. Cl.: G02B 27/01, G02B 30/50, G02B 3/14

(54) **DISPLAY UNIT AND METHOD FOR OPERATING A DISPLAY UNIT**

(30) Priority: 12.06.2020 DE 102020115648
(71) Applicant: Optotune AG, 8953 Dietikon (CH)
(72) Inventor: ASCHWANDEN, Manuel, 6319 Allenwinden (CH); NIEDERER, David Andreas, 5024 Küttigen (CH)
(74) Representative: Schulz Junghans Patentanwälte PartGmbB

(57) **Abstract**

Display unit (1) comprising a pixel-matrix (11) with multiple pixels (110) and at least one refractive optical element (12) having a refractive power, wherein the pixels (110) are arranged to emit light having a definable color and intensity, the light emitted by the pixel-matrix (11) passes through the refractive optical element (12), and the refractive power is tunable.

## Description

A display unit described herein is arranged to depict static and/or moving pictures. In particular, the display unit is arranged to enable stereoscopic representation of static and/or moving pictures. For example, the display unit is arranged to generate a three-dimensional impression of pictures displayed.

The display unit comprises a pixel-matrix with multiple pixels. The pixels are arranged to emit light of definable color and intensity. The definable color and intensity may be generated by means of additive color mixing. In particular, each pixel comprises multiple LEDs, which are arranged to emit light in different wavelength ranges. The definable color and intensity may be defined by mixing the light of the multiple LEDs of a pixel. In particular, the LEDs may be micro-LEDs.

The display unit comprises at least one refractive optical element having a refractive optical power. At least some of the light emitted by the pixel-matrix passes through the refractive optical element. The refractive optical power is tunable. Thus, the at least one property of the refractive optical element may be altered intentionally, which results in a change of the refractive optical power.

The display unit comprises the pixel-matrix with multiple pixels and the at least one refractive optical element having the refractive power, wherein the refractive power is tunable. The pixels are arranged to emit light having a definable color and intensity. The light emitted by the pixel-matrix passes through the refractive optical element.

Among others, the display unit described here is based on the following considerations. Most existing stereoscopic displays suffer from accommodation convergence conflict: presenting accurate binocular disparity (supporting convergence on any point), but only allowing the viewer to accommodate on the display surface. As a result, content is restricted to a "zone of comfort" close to the surface, mitigating accommodation-convergence conflict. Hence, the application of these conventional display units as stereoscopic display units is limited and the conventional displays do not enable a head mounted true light field display.

The display unit described herein makes use of the idea, among other things, that the perceived distance of the pixel may be altered by means of a refractive optical element, wherein the refractive power of said optical element may be tuned.

Advantageously, a display unit comprising the refractive optical element with tunable optical power makes movement of refractive optical elements, in particular lenses, along the optical axis superfluous. Thus, the refractive optical element enables a particularly compact display unit. Such display unit is well suited for the application in head mounted display units, because vibration and noise due to movement of lenses is avoided.

According to one embodiment of the display unit, the refractive optical element is a tunable lens or a tunable lens array. The tunable lens or each lens of the tunable lens array comprises exactly one tunable surface or exactly two tunable surfaces, wherein the refractive power is tunable by changing the curvature of the tunable surface or the tunable surfaces. The tunable surface(s) may be an interface between two liquids. Alternatively, the tunable surface may be a surface of a flexible membrane. In particular, the tunable lens or the tunable lens array comprises a container which is filled with a liquid. On a least one side, the container may be delimited by the flexible membrane. In particular, the container is limited on two opposing sides by the flexible membrane.

The refractive optical power may be altered, by changing the pressure of the liquid. For example, the pressure of the liquid is changed by means of a lens shaper or multiple lens shapers. The lens shaper is pushed against the membrane, whereby the pressure of the liquid in the container is increased and the curvature of the tunable surface(s) is altered. Advantageously, the tunable lens or the tunable lens array enables fast and efficient tuning of the optical power.

According to one embodiment, the pixels are arranged in a first plane, the lenses of the lens array are arranged in a second plane. The lenses of the lens array are arranged at the corner points of an imaginary repetitive hexagonal line pattern, at the corner points of an imaginary repetitive rectangular line pattern or along the lines of an imaginary concentric circular pattern.

In particular, the pixel-matrix may comprise multiple pixel elements, wherein each pixel element comprises multiple pixels. Each pixel element is arranged to display a sub-domain of the image to be depicted by means of the display unit. Each display element may be assigned to on or a plurality of lenses of the tunable lens array. Thus, the light emitted by each display element goes through the tunable lenses assigned to the display element.

According to one embodiment of the display unit, the refractive power of the optical element is tunable in a range from -40 diopters to +30 diopters.

According to one embodiment, the refractive power of the optical element is tunable with a display frequency which is at least 50% of a refresh rate of the pixel matrix. Preferably, the display frequency of the optical element is at least 100% of the refresh rate of the pixel matrix. For example, the display frequency is at least 45 Hz, preferably at least 60 Hz, particularly preferred 90Hz or highly preferred 120 Hz.

In particular, the optical element is arranged to tune the optical power with said display frequency with a peak to peak amplitude of at least 2 diopters, in particular at least 10 diopters, preferably at least 20 diopters.

According to one embodiment, the pixels are arranged to emit light of a definable color and intensity in an on-state and the pixels do not emit light in an off-state. The pixels are arranged to be switched into the on-state for a definable timespan, while the refractive power of the optical element is in a designated range and the refractive power is tuned with the display frequency. For example, the definable timespan is a timespan, in which the refractive power of the optical element is changed by less than one diopter, in particular less than 0.5 diopters, while the refractive power is tuned with the display frequency. In particular, the definable time span is less than a millisecond, in particular less than 400 microseconds.

According to one embodiment, the display unit is a virtual reality display, in particular a head mounted virtual reality display unit. The display unit may be arranged to be placed in a distance to the users eye of less than 50 mm, preferably less than 20 mm, highly preferred less than 10 mm. In particular, the display unit comprises two pixel-matrices and two refractive optical elements. Each pixel matrix is assigned to a refractive optical element. The optical power of the refractive optical elements may be tuned separately. For example the display unit has a field of view of at least 50°, in particular at least 70°, preferably at least 150°.

A method for operating a display unit is also specified. In particular, the display unit described here can be operated with the method. That means all features disclosed for the display unit are also disclosed for the method and vice versa.

The method for operating a display unit concerns a display unit comprising a pixel matrix with multiple pixels and at least one refractive optical element, wherein the refractive optical element has a refractive power, which is tunable. The method comprises the steps of
a) tuning the refractive optical power in an oscillating manner;
b) switching the pixels from an off-state in an on-state for a definable time span, when the refractive power is within a dedicated range, wherein
the pixel emits light of definable color and intensity in the on-state and the pixel does not emit light in the off-state.

In method step a) the refractive optical power is tuned with the display frequency. For example, the display frequency is at least 45 Hz, 60 Hz, 90 Hz or 120 Hz. In particular, the refractive optical power is tuned at display frequency with a peak to peak amplitude of at least 2 diopters, preferably at least 10 diopters or highly preferred at least 20 diopters. The refractive optical power is altered in the manner of a sawtooth-signal. In particular, the tuning of the optical power is driven by means of a sawtooth-signal. Thus, the time for all tuning states is evenly distributed over all tuning states.

In method step b) the length of the definable timespan specifies the duration of the on-state of a pixel within one cycle of the oscillating tuning of the refractive optical power. In particular, the definable time span is selected to be as long as necessary, in order to achieve a sufficient intensity of emitted light. Furthermore, the definable time span is selected to be as short as possible, in order to have minimum change of the refractive power during the definable time span. Advantageously, method steps a) and b) enable the three-dimensional representation of images in a light field. Thus, the convergence conflict does not occur.

According to one embodiment in method step a) the refractive power is tuned with a frequency of at least 45Hz, in particular at least 60Hz, and an amplitude of at least 2 diopters in particular at least 20 diopters.

According to one embodiment the refractive power is set to an offset value, and the refractive power oscillates around said offset value in method step a). In particular, the offset value is between -40 and +30 diopters and the offset value depends on the ametropia of the person using the display. For example, the refractive power is set to said offset value before method step a). Advantageously, the display unit is arranged to compensate for ametropia of the person using the display unit.

Further advantages and advantageous refinements and developments of the display unit and the method for operating the display unit result from the following exemplary embodiments illustrated in connection with the figures.
Figure 1, 2, 3 and 4 show exemplary embodiments of display units in sectional views;
Figure 5, 6 and 7 show exemplary embodiments of refractive elements of display units in top views. Identical, identical or identically acting elements are provided with the same reference symbols in the figures. The figures and the proportions of the elements shown in the figures among one another are not to be regarded as to scale. Rather, individual elements may be exaggerated in size for better displayability and/or for better comprehensibility.

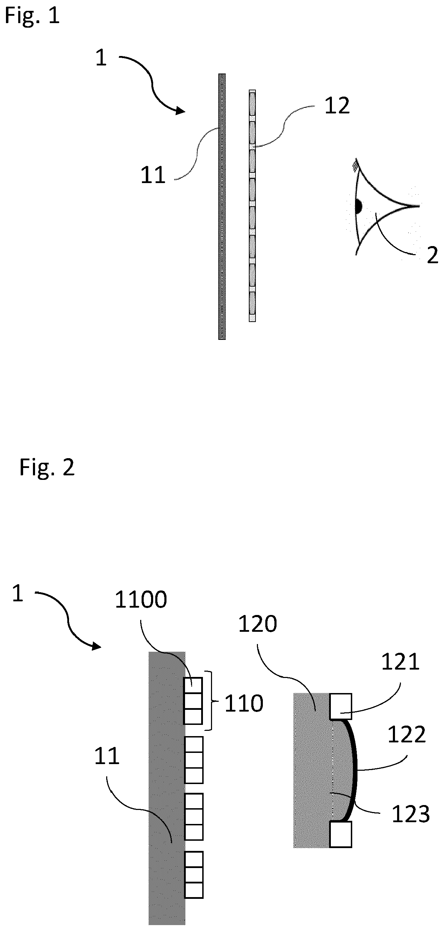

Figure 1 shows an exemplary embodiment of a display unit 1 comprising a pixel-matrix 11 and a refractive optical element 12. The refractive optical power of the optical element 12 is tunable. When operating the display unit 1, the optical power of the optical element 12 is tuned to an offset value between -40 diopters and +30 diopters. The offset value may be selected such that ametropia of a user 2 utilizing the display unit 1 is compensated. When operating the display unit, the optical power is modulated with a display frequency. The display frequency may be at least 50% or at least 100% of the refresh rate of the pixel-matrix 11. For example, the refresh rate is at least 90 Hz, in particular at least 120 Hz.

Figure 2 shows an exemplary embodiment of a display unit 1. In this embodiment, the pixel-matrix 11 comprises multiple pixels 110, wherein each pixel consists of subpixels 1100. The subpixels 1100 of a pixel 110 are arranged to emit light of different wavelength ranges. Thus, each pixel 110 may emit additively mixed light of a desired color and intensity. For example, the subpixels 1100 are arranged to emit light in a red, green or blue wavelength range. In particular, each subpixel 1100 comprises a micro-LED.

The refractive optical element 12 comprises a tunable lens 120 having exactly one tunable optical surface 122. The tunable lens 120 comprises a lens shaper 121, a membrane and a liquid 123. The lens shaper 121 is arranged to push against a membrane, whereby the pressure of the liquid 123 is increased. Increased pressure of the liquid results in an increased curvature of the tunable optical surface 122. In operation, the light emitted by the pixel-matrix 11 goes through the refractive optical element 12 and is refracted at the tunable optical surface 122.

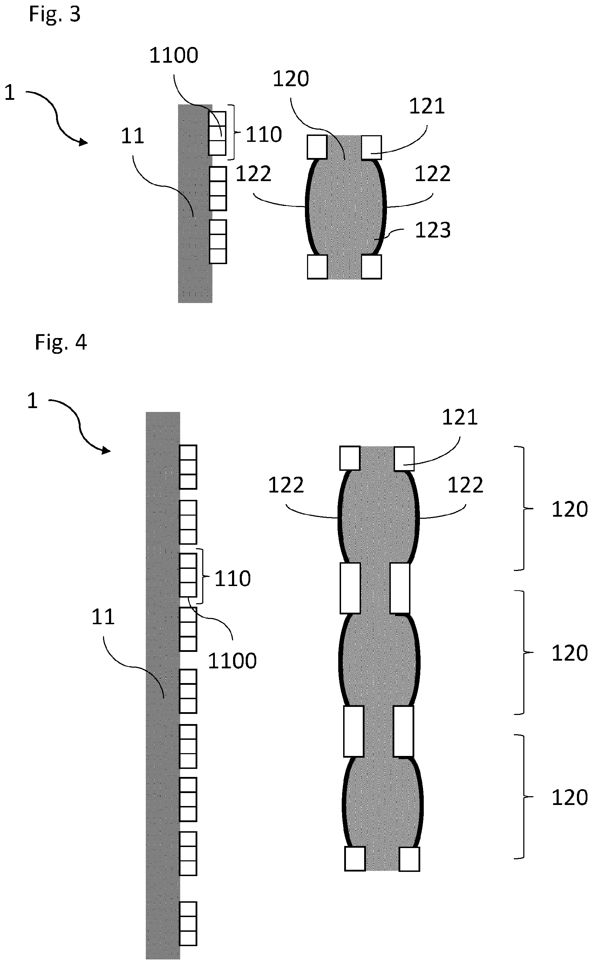

Figure 3 shows an exemplary embodiment of a display unit 1 having exactly two tunable surfaces 122. The curvature of each tunable surface is controlled by means of a lens shaper 121. The lens shaper 121 respectively has an opening, into which the membrane expands, when the pressure of the liquid 123 is increased.

Figure 4 shows an exemplary embodiment of a display unit, wherein the refractive optical element comprises a lens array with tunable lenses. The refractive optical element has exactly two tunable optical surfaces 122. Each tunable optical surface is part of a flexible membrane. Each tunable surface 122 is in direct contact with a lens shaper 121. The lens shaper 121 has a mesh structure, wherein openings in the mesh structure define the aperture of each lens of the tunable lens array. The openings may have a circular contour having a diameter of 2 millimeters.

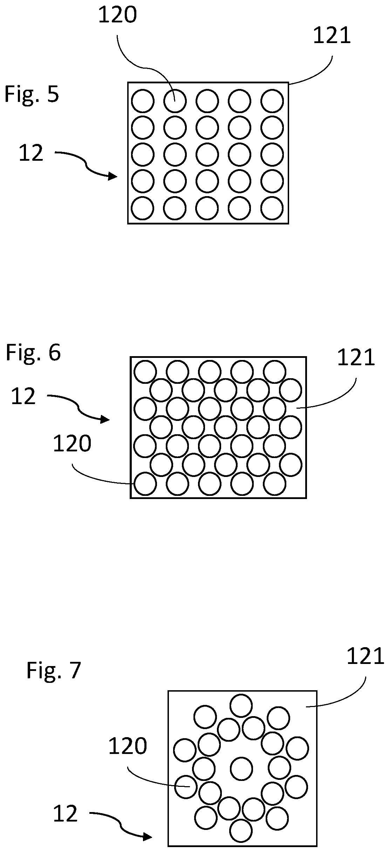

Figure 5 shows an exemplary embodiment of a refractive optical element 12 in a top view. The opticl element 12 comprises a lens array, with multiple lenses 12 which a arranged in a common plane. The lenses are defined by openings in the lens shaper 121. For example the openings have a diameter of about 2 mm. In the exemplary embodiment, the lenses 120 are arranged at the edges of an imaginary rectangular gridlines. Alternatively, the lenses 120 may be arranged at the edges of imaginary hexagonal gridlines.

Figure 6 shows an exemplary embodiment of a refractive optical element 12 in top view. The exemplary embodiment of figure 6 differs from the exemplary embodiment of figure 5 in the arrangement of the lenses 120.

Figure 7 shows an exemplary embodiment of a refractive optical element 12 in top view. The exemplary embodiment of figure 7 differs from the exemplary embodiment of figures 5 and 6 in the arrangement of the lenses 120. The lenses 120 are arranged on imaginary circular lines in a concentric manner.

The invention is not restricted to the exemplary embodiments by the description based on these. Rather, the invention encompasses every new feature and every combination of features, which in particular includes every combination of features in the patent claims, even if this feature or this combination itself is not explicitly specified in the patent claims or exemplary embodiments. "

### List of reference signs

- 1: display unit
- 11: pixel-matrix
- 110: pixel
- 1100: subpixel
- 12: refractive optical element
- 120: lens
- 121: lens shaper
- 122: tunable optical surface
- 123: liquid
- 2: user

## Claims

1. Display unit (1) comprising a pixel-matrix (11) with multiple pixels (110) and at least one refractive optical element (12) having a refractive power, wherein
the pixels (110) are arranged to emit light having a definable color and intensity,
the light emitted by the pixel-matrix (11) passes through the refractive optical element (12),
and
the refractive power is tunable.

2. Display unit (1) according to claim 1, wherein
the refractive optical element (12) is a tunable lens (120) or a tunable lens array,
the tunable lens (120) or each lens (120) of the tunable lens array comprises exactly one tunable surface (122) or exactly two tunable surfaces (122), wherein
the refractive power is tunable by changing the curvature of the tunable surface (122) or the tunable surfaces (122).

3. Display unit (1) according to the preceding claim, wherein
the pixels (110) are arranged in a first plane,
the lenses (120) of the lens array are arranged in a second plane, and
the lenses (120) are arranged at the corner points of an imaginary repetitive hexagonal line pattern, at the corner points of an imaginary repetitive rectangular line pattern or along the lines of an imaginary concentric circular pattern.

4. Display unit (1) according to one of the preceding claims, wherein the refractive power of the optical element may be tuned in a range -40 diopters to +30 diopters.

5. Display unit (1) according to one of the preceding claims, wherein the refractive power of the optical element (11) may be tuned with a display frequency of at least 45 Hz, preferably at least 60 Hz.

6. Display unit (1) according to the preceding claim, wherein
the pixels (110) are arranged to emit light of a definable color and intensity in an on-state and the pixels do not emit light in an off-state,
the pixels (110) are arranged to be switched into the on-state for a definable timespan, while the refractive power of the optical element (12) is in a designated range and the refractive power is tuned with the display frequency.

7. Display unit (1) according to one of the preceding claims, wherein the display unit (1) is a virtual reality display, in particular a head mounted virtual reality display unit.

8. Display unit (1) according to one of the preceding claims, wherein each pixel (110) comprises a micro LED.

9. Method for operating a display unit, wherein the display unit (1) comprises a pixel matrix (11) with multiple pixels (110) and at least one refractive optical element (12), wherein the refractive optical element (12) has a refractive power, which is tunable, comprising the steps of,
a) tuning the refractive optical power in an oscillating manner;
b) switching the pixels (110) from an off-state in an on-state for a definable time span, when the refractive power is within a dedicated range, wherein
the pixel (110) emits light of definable color and intensity in the on-state and the pixel does not emit light in the off-state.

10. Method according to the preceding claim, wherein in method step a) the refractive power is tuned with a frequency of at least 45Hz, in particular at least 60Hz, and an amplitude of at least 5 diopters in particular at least 10 diopters.

11. Method according to one of the preceding claims, wherein the refractive power set to an offset value, and the refractive power oscillates around said offset value in method step a).

12. Method according to the preceding claim, wherein the offset value is between -40 and +30 diopters and the offset value depends on the ametropia of the person using the display unit (1).
